# EUROPÄISCHE PATENTANMELDUNG

(11) **EP 1 715 242 A2**
(43) Veröffentlichungstag der Anmeldung: **25.10.2006**
(21) Anmeldenummer: 06006464.9
(22) Anmeldetag: 29.03.2006
(51) Int. Cl.: F21S 8/00, F21V 19/00, F21Y 101/02

(54) **Leiterplattenbeleuchtung**

(30) Priorität: 13.04.2005 DE 102005018282
(71) Anmelder: WÜRTH ELEKTRONIK GmbH & Co. KG, D-74676 Niedernhall (DE)
(72) Erfinder: Kallee, Werner, 74177 Bad Friedrichshall (DE)
(74) Vertreter: Patentanwälte Ruff, Wilhelm, Beier, Dauster & Partner

(57) **Zusammenfassung**

Zur Beleuchtung von Anzeigefeldern einer Leiterplatte (16) von der Rückseite (18) her wird eine Anordnung vorgeschlagen, die ein zur Rückseite (18) der Leiterplatte (16) hin offenes Gehäuse aufweist, das von der Rückseite der Leiterplatte her mit dieser verbunden wird. Das Gehäuse enthält einen Gehäusemantel (1) mit durchgehenden Bohrungen (8) zur Aufnahme von Einpressstiften (13) und eine Rückwand (5), an deren Innenseite eine Leuchtdiode (17) angeordnet ist, die ihre Stromversorgung von den Einpressstiften her erhält.

## Beschreibung

Die Erfindung betrifft eine Anordnung, mit der Leiterplatten bereichsweise von der Rückseite her beleuchtet werden können.

Es gibt Fälle, wo die Frontplatte eines elektronischen Gerätes gleichzeitig als Leiterplatte ausgebildet ist, so dass die Frontplatte eine doppelte Funktion aufweist. Bei Frontplatten ist es in vielen Fällen erwünscht, bestimmte Signalzustände oder sonstige Anzeigen optisch erkennbar zu machen, beispielsweise dadurch, dass ein bestimmtes Feld der Frontplatte beleuchtet wird. Es kann sich dabei um Tastenfelder oder Signalfelder oder sonstige Anzeigefelder handeln.

Der Erfindung liegt die Aufgabe zu Grunde, eine einfach durchzuführende Möglichkeit zu schaffen, Leiterplatten von der Rückseite her bereichsweise beleuchten zu können, und diese Beleuchtung auch von bestimmten Zuständen der Leiterplatte abhängig zu machen.

Zur Lösung dieser Aufgabe schlägt die Erfindung eine Anordnung mit den im Anspruch 1 genannten Merkmalen vor. Weiterbildungen der Erfindung sind Gegenstand von Unteransprüchen.

Die Anordnung enthält also ein Gehäuse, das direkt an der Rückseite der Leiterplatte angebracht wird und in dem eine Leuchtdiode untergebracht ist. Diese beleuchtet das Innere des Gehäuses und damit dann auch ein Anzeigefeld, wenn in der Leiterplatte ein solches durchsichtiges oder durchscheinendes Anzeigefeld vorhanden ist. Die Befestigung erfolgt direkt an der Leiterplatte selbst, so dass keine zusätzlichen Befestigungsanordnungen oder Halteelemente benötigt werden. Die Leiterplatte bildet dann, sobald die Anordnung mit ihr verbunden ist, eine Einheit.

In Weiterbildung der Erfindung kann vorgesehen sein, dass auch die Rückwand des Gehäuses in Einpresstechnik mit dem Gehäusemantel verbunden ist.

Die der Leiterplatte zugewandte Stirnseite des Gehäuses ist, sofern eine flächige Anlage längs der Stirnkanten gewünscht ist, so ausgebildet, dass sie in der gleichen Fläche liegt wie die Rückseite der Leiterplatte. Bei einer ebenen Leiterplatte liegen also die Stirnkanten des Gehäusemantels ebenfalls in einer Ebene.

Üblicherweise wird als Rückwand ebenfalls ein ebenes Element verwendet, so dass dann auch die der Leiterplatte abgewandte Stirnseite des Gehäuses in einer Ebene liegt, wobei vorzugsweise beide Ebenen parallel zueinander verlaufen. In Einzelfällen ist es natürlich auch denkbar, beispielsweise die Rückwand schräg gegenüber der Vorderseite verlaufen lassen, wenn eine schräge Beleuchtung gewünscht wird.

Es ist ebenfalls möglich, dass die Achse des Gehäusemantels schräg gegenüber der Leiterplatte verläuft, wobei im Normalfall eine senkrechte Anordnung sinnvoll ist.

Wenn mit der Anordnung eine Begrenzung der Beleuchtung auf einen bestimmten Bereich gewünscht wird, was der Normalfall ist, kann erfindungsgemäß vorgesehen sein, dass der Gehäusemantel mit Ausnahme der beiden Stirnseiten geschlossen ist. Dann ist dafür gesorgt, dass kein Licht seitlich aus dem Gehäusemantel austritt. Es kann aber auch Fälle geben, wo das seitliche Austreten von Licht nicht stört oder gewünscht wird. In diesen Fällen kann auch vorgesehen sein, dass der Gehäusemantel nicht vollständig geschlossen ist.

Es wurde bereits erwähnt, dass der Gehäusemantel mit der Leiterplatte in Einpresstechnik verbunden ist. Zu diesem Zweck kann erfindungsgemäß in Weiterbildung vorgesehen sein, dass in der der Leiterplatte zugeordneten Stirnkante des Gehäusemantels mindestens eine Öffnung angeordnet ist, aus der ein Einpressstift heraus ragt. Diese Öffnung ist vorzugsweise so ausgebildet, dass beim Einpressen des herausragenden Einpressstifts, was durch Kraftaufbringen auf den Gehäusemantel erreicht wird, der Einpressstift nicht weiter in die Öffnung des Gehäusemantels eingepresst werden kann. Dies kann beispielsweise durch eine Sacklochbohrung erreicht werden, oder durch eine auch die Tiefe gehende Bohrung mit einer Anlageschulter.

Beispielsweise kann vorgesehen sein, dass durch den Gehäusemantel mindestens eine Bohrung von Stirnkante zu Stirnkante hindurch geht, in die dann ein mindestens einseitig aus der Stirnkante herausragender Einpressstift eingesetzt ist, vorzugsweise aber ein Einpressstift, der aus beiden Stirnkanten herausragt. Er kann dann als einzelnes Bauelement dazu verwendet werden, den Gehäusemantel mit der Leiterplatte und mit der Rückwand zu verbinden.

Um auch kleine Bereiche der Leiterplatte beleuchten zu können und diese kleinen Bereiche eng aneinander heran zu rücken, kann der Gehäusemantel eine kühne Wandstärke aufweisen. Um dennoch Bohrungen für Einpressstifte unterbringen zu können, kann der Gehäusemantel in bestimmten Bereichen eine verdickte Wandstärke aufweisen, um dort die Einpressstifte unterzubringen. Wenn diese Bereiche verdickter Wandstärke unsymmetrisch angebracht werden, kann man durch entsprechende verdrehte Anordnung der Gehäusemäntel die einzelnen Gehäuse auch trotzdem sehr eng aneinander heran rücken.

Der Einpressstift, der in eine Bohrung der Leiterplatte und/oder eine Bohrung der Rückwand eingepresst wird, stellt eine mechanische Verbindung her. Es ist sinnvoll, ihn auch dazu zu verwenden, eine elektrische Verbindung herzustellen. Zu diesem Zweck ist der Einpressstift aus elektrisch leitendem Material hergestellt. Wenn er in eine durchkontaktierte Bohrung eingepresst wird, kann er auch dazu verwendet werden, eine Stromversorgung von der Leiterplatte zu der Rückwand herzustellen. Bei dieser Stromversorgung zur Rückwand kann es sich um eine Stromversorgung handeln, die zu anderen Zwecken verwendet wird, insbesondere aber um die Stromversorgung der in dem Gehäuse angeordneten Leuchtdiode.

Es ist ebenfalls möglich, dass die Stromversorgung der Leuchtdiode auf anderem Wege erfolgt, beispielsweise durch ein Lötpad an der Außenseite der Rückwand.

Erfindungsgemäß kann in Weiterbildung vorgesehen sein, dass die Innenseite des die Leuchtdiode aufnehmenden Gehäuses als Reflektor ausgebildet ist, um das Licht auf die Rückseite der Leiterplatte zu richten. Hierzu kann einerseits die Innenseite der Rückwand selbst dienen, insbesondere aber auch die Innenseite des Gehäusemantels.

Bei der Ausbildung als Reflektor geht es in erster Linie um die Ausbildung der Form der Oberfläche.

Eine Möglichkeit, wie man die Innenseite des Gehäusemantels so ausgestalten kann, dass sie als Reflektor wirkt, besteht darin, sie von der Rückwand zur Leiterplatte mindestens bereichsweise divergierend auszubilden.

Die Querschnittsform des die Leuchtdiode aufnehmenden Gehäuses kann den Anforderungen des Einzelfalls entsprechend ausgebildet sein. Beispielsweise wird von der Erfindung vorgeschlagen, wenn eine rechtwinklige oder quadratische Anzeigefläche beleuchtet werden soll, die Querschnittsform des Gehäuses auch rechteckigen oder quadratisch auszubilden.

Es ist aber auch beispielsweise denkbar, wenn eine Rautenform der Anzeigefläche beleuchtet werden soll, die vier Seitenwände rautenförmig anzuordnen.

Die Anpassung der Querschnittsform des Gehäuses an die Form der Anzeigeflächen ist nur dann besonders sinnvoll, wenn mehrere Gehäuse nahe aneinander gerückt werden sollen.

Eine weitere Möglichkeit, wie der Gehäusemantel ausgebildet werden kann, besteht darin, ihn als Zylinder, insbesondere als Kreiszylinder auszubilden.

In nochmaliger Weiterbildung der Erfindung wird vorschlagen, den Gehäusemantel mit der Rückwand, dem mindestens einen Einpressstift und der Leuchtdiode in zusammengesetztem Zustand und mit der Verdrahtung der Stromversorgung der Leuchtdiode durch den Einpressstift als Baueinheit auszubilden. Diese Baueinheit kann dann bei der Bestückung der Leiterplatte in einem Vorgang mit dieser verbunden werden.

Wenn einer Frontplatte als Leiterplatte ausgebildet ist und mehrere Anzeigefelder aufweisen soll, können mehrere vorzugsweise identisch ausgebildete derartige Baueinheiten an der Rückseite der Leiterplatte angeordnet werden.

Bei der Anordnung mehrerer Gehäuse nebeneinander an der Rückseite einer Leiterplatte kann auch vorgesehen sein, dass die Rückwand mehrere oder dann aller Gehäusemäntel von einer durchgehenden Leiterplatte gebildet wird.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:
Figur 1 in vereinfachter Form die perspektivische Darstellung einer als Baueinheit ausgebildeten Anordnung nach der Erfindung;
Figur 2 die Ansicht eines Gehäuses von unten;

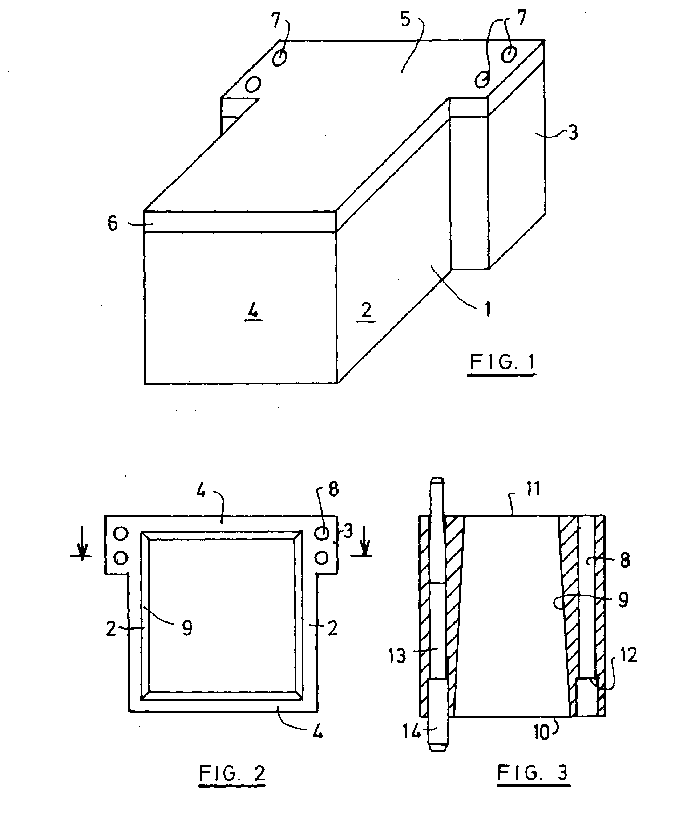

Figur 2 einen Schnitt durch einen Gehäusemantel mit eingesetztem Kontaktstift etwa längs Linie IV-IV in Figur 3; und

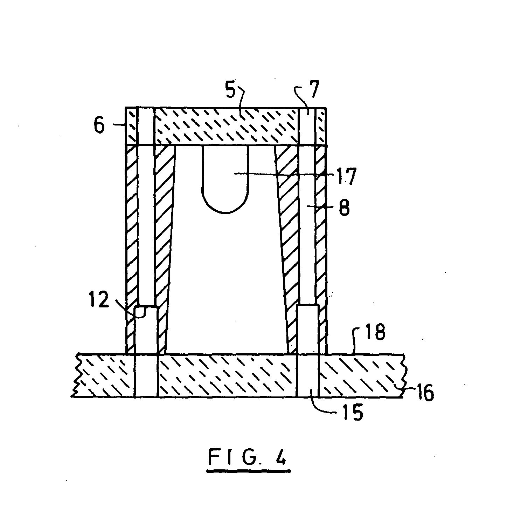

Figur 4 einen der Figur 3 entsprechenden Schnitt bei Anordnung hinter einer Leiterplatte und mit der Rückwand;

Figur 1 zeigt eine perspektivische Ansicht eines Gehäuses zur Unterbringung einer Leuchtdiode. Das Gehäuse erweist einen Gehäusemantel 1 auf, der im dargestellten Beispiel vier rechtwinklig zueinander angeordnete Seitenwände aufweist, von denen die in Figur 1 rechts und links angeordneten Seitenwände 2 einen Bereich 3 mit verdickter Wand aufweisen. Die übrigen Seitenwände 4 weisen diese Verdickung nicht auf. Auf der in Figur 1 nach oben gerichteten Rückseite des Gehäusemantels 1 ist eine Rückwand 5 angeordnet und mit dem Gehäusemantel 1 verbunden. Die Rückwand 5 ist so ausgebildet, dass ihre Außenkanten 6 mit den Außenseiten der Seitenwände 2, 4 fluchten. In dem verdickten Bereich 3 der Seitenwände 2 sind auf der Rückseite der Rückwand 5 Öffnungen 7 zu sehen, bei denen es sich um durchkontaktierte Bohrungen handelt. Innerhalb der als Leiterplatte ausgebildet Rückwand 5 sind Lagen leitenden Materials angeordnet, in denen eine elektrisch leitende Verbindung zwischen den durchkontaktierte Bohrungen 7 und der im Inneren der Anordnung angeordneten Leuchtdiode hergestellt ist.

Figur 2 zeigt eine an Ansicht der Anordnung der Figur 1 von unten in Figur 1. In den verdickten Bereichen 3 der Seitenwände 2 sind Bohrungen 8 angeordnet, die mit den durchkontaktierte Bohrungen 7 der Rückwand 5 fluchten. Die Innenseiten 9 der Seitenwände 2, 4 liegen in Ebenen, die leicht divergieren, siehe auch Figur 3.

Das Divergieren der Innenseiten 9 der Seitenwände geht auch aus Figur 3 hervor. In Figur 3 ist die der Leiterplatte zugeordnete Stirnfläche 10 des Gehäuses unten dargestellt, während die Stirnseite des Gehäuses, auf der die Rückwand 5 befestigt wird, oben ist. Die Innenseiten 9 divergieren also von der Rückseite des Gehäusemantels 1 zur Vorderseite hin.

Bei der rechten Bohrung 8 in Figur 3 ist zu sehen, dass es sich um eine Stufenbohrung handelt, bei der eine Schulter 12 gebildet ist. Die Schulter 12 ist zur Vorderseite 10 hin gerichtet, also zur Leiterplatte.

Der in die Bohrung 8 von der Vorderseite 10 her einzusetzende Einpressstift 13 weist einen Einpressbereich 14 auf, der einen etwas größeren Durchmesser aufweist als der Rest des Stiftes. Dieser Einpressbereich 14 ist in seinem Endbereich für die in den Figuren 1 bis 3 nicht dargestellte Leiterplatte bestimmt. Am Ende des verdickten Bereichs 14 liegt dieser dann an der Schulter 12 an, so dass beim Einpressen der Stift 13 wirklich in die Bohrung der Leiterplatte gepresst wird und nicht in den Gehäusemantel zurück geschoben wird.

Nun zu Figur 4. Figur 4 zeigt einen Schnitt etwa wie Figur 3, aber zur Vereinfachung der Darstellung ohne den Einpressstift 13, dafür aber mit aufgesetzter Rückwand 5. Die Bohrungen 8 in dem Gehäusemantel 1 fluchten mit den Bohrungen 7 in der Rückwand 5 und mit entsprechenden durchkontaktierten Bohrungen 15 in der Leiterplatte 16. Die Figur 4 stellt den Zustand da, wie das Gehäuse der Figuren 1 bis 3 an der Rückseite der Leiterplatte 16 angebracht wird, jedoch ohne die Einpressstifte 13.

Die an der Innenseite der Rückwand 5 angebrachte schematisch dargestellte Leuchtdiode 17 erhält ihren Strom von der Leiterplatte 16 her über die Einpressstifte 13 und die Rückwand 5. Das Anzeigefenster, das durch die Leuchtdiode 17 beleuchtet werden soll, liegt hinter der Schnittebene und ist daher nicht zu sehen. Die Rückwand 5 mit der Leuchtdiode 17 kann mit den Einpressstiften 13 und dem Gehäusemantel 1 verbunden werden. Damit stellt die in Figur 1 dargestellte Anordnung eine Baueinheit dar, die dann mit der Leiterplatte 16 von deren Rückseite 18 her durch einen Einpressvorgang verbunden wird.

Wenn mehrere Gehäuse dieser Art nebeneinander angeordnet werden, ist es denkbar, eine durchgehende Rückwand 5 zu verwenden.

## Patentansprüche

1. Anordnung zur Anbringung einer Leuchtdiode an der Rückseite (18) einer von hinten zu beleuchtenden Leiterplatte (16), mit
1.1 einem Gehäusemantel (1), der
1.2 zwei offene einander gegenüberliegende Stirnseiten (10,11) aufweist,
1.3 deren eine zur Anlage an der Rückseite (18) der Leiterplatte (16) bestimmt ist und
1.4 deren andere Stirnseite (11) eine Rückwand (5) aufweist,
1.5 an der die Leuchtdiode (17) in das Innere des Gehäusemantels (1) gerichtet angeordnet ist, wobei
1.6 der Gehäusemantel (1) zur Verbindung mit der Leiterplatte (16) in Einpresstechnik ausgebildet ist.

2. Anordnung nach Anspruch 1, bei der der Gehäusemantel (1) in Einpresstechnik mit der Rückwand (5) verbunden ist.

3. Anordnung nach Anspruch 1 oder 2, bei der die der Leiterplatte (16) zugeordnete Stirnseite (10) und/oder die die Rückwand (5) aufweisende Stirnseite (11) des Gehäusemantels (1) jeweils in einer Ebene liegen, wobei insbesondere beide Ebenen parallel zueinander verlaufen.

4. Anordnung nach einem der vorhergehenden Ansprüche, bei der der Gehäusemantel (1) mit Ausnahme der beiden Stirnseiten (10, 11) geschlossen ist.

5. Anordnung nach einem der vorhergehenden Ansprüche, bei der in der der Leiterplatte (16) zugeordneten Stirnkante des Gehäusemantels (1) mindestens eine Öffnung angeordnet ist, aus der ein Einpressstift (13) heraus ragt.

6. Anordnung nach einem der vorhergehenden Ansprüche, bei der durch den Gehäusemantel (1) mindestens eine Bohrung (8) von Stirnkante zu Stirnkante hindurch geht, in der ein beidseits aus der jeweiligen Stirnkante herausragender Einpressstift (13) eingesetzt ist.

7. Anordnung nach Anspruch 5 oder 6, bei der die Bohrung (8) in einem Bereich (3) des Gehäusemantels (1) mit verdickter Wandstärke angeordnet ist.

8. Anordnung nach einem der Ansprüche 5 bis 7, bei der der Einpressstift (13) an mindestens einem seiner heraus ragenden Enden kontaktiert ist.

9. Anordnung nach einem der Ansprüche 5 bis 8, bei der die Stromversorgung der Leuchtdiode durch den Kontaktstift (13) erfolgt.

10. Anordnung nach einem der vorhergehenden Ansprüche, bei der die Stromversorgung der Leuchtdiode (17) durch ein Lötpad an der Außenseite der Rückwand (5) erfolgt.

11. Anordnung nach einem der vorhergehenden Ansprüche, bei der die Innenseite (9) des die Leuchtdiode (17) aufnehmenden Gehäuses als Reflektor ausgebildet ist.

12. Anordnung nach einem der vorhergehenden Ansprüche, bei der die Innenseite (9) des Gehäusemantels (1) als Reflektor ausgebildet ist.

13. Anordnung nach einem der vorhergehenden Ansprüche, bei dem die Innenseite (9) des Gehäusemantels (1) mindestens teilweise von der rückseitigen Stirnfläche (11) zu der Leiterplatte (16) divergierend ausgebildet ist.

14. Anordnung nach einem der vorhergehenden Ansprüche, bei der der Gehäusemantel (1) vier insbesondere rechtwinklig zueinander angeordnete Seitenwände (2, 4) aufweist.

15. Anordnung nach einem der Ansprüche 1 bis 13, bei der der Gehäusemantel als Zylinder, insbesondere als Kreiszylinder ausgebildet ist.

16. Anordnung nach einem der vorhergehenden Ansprüche, bei der der Gehäusemantel (1) mit der Rückwand (5), den Einpressstiften (13) und der Leuchtdiode (17) als Baueinheit ausgebildet ist.

17. Anordnung nach Anspruch 16, bei der mehrere vorzugsweise identisch ausgebildete Baueinheiten an der Rückseite (18) der Leiterplatte (16) angeordnet sind.

18. Anordnung nach Anspruch 17, bei der eine durchgehende Leiterplatte die Rückwand mehrere Gehäusemäntel (1) bildet bzw. die Rückwände (5) mehrerer Gehäusemäntel (1) zu einer durchgehenden Rückwand zusammengefasst sind.
